# EUROPÄISCHE PATENTSCHRIFT

(11) **EP 1 291 719 B1**
(45) Veröffentlichungstag und Bekanntmachung des Hinweises auf die Patenterteilung: **14.11.2007**
(21) Anmeldenummer: 02015054.6
(22) Anmeldetag: 05.07.2002
(51) Int. Cl.: G03F 7/20, G02B 13/24, G02B 15/14

(54) **Projektionsbelichtungsanlage**
Projection exposure apparatus
Appareil d'exposition par projection

(30) Priorität: 05.09.2001 DE 10143385
(43) Veröffentlichungstag der Anmeldung: 12.03.2003
(73) Patentinhaber: CARL ZEISS SEMICONDUCTOR MANUFACTURING TECHNOLOGIES AG, 73447 Oberkochen (DE)
(72) Erfinder: Kneer, Bernhard, 89605 Altheim (DE); Richter, Gerald, Dr., 73453 Abtsgmünd (DE)
(74) Vertreter: Ostertag, Ulrich

(56) Entgegenhaltungen:
- EP-A- 0 992 853
- DE-A- 19 855 108
- DE-A- 19 942 281
- US-A- 4 765 722
- US-A- 4 787 719
- US-A- 5 526 186
- US-A- 6 014 455
- US-A- 6 061 180
- US-A- 6 091 551

## Beschreibung

Die Erfindung betrifft eine Projektionsbelichtungsanlage gemäß dem Oberbegriff des Anspruchs 1.

Eine derartige Projektionsbelichtungsanlage ist aus der US-A-6 014 455 bekannt. Bei dem dort beschriebenen Projektionsobjektiv besteht eine erste Linsengruppe mit insgesamt positiver Brechkraft aus einer Sammellinse, die Teil eines Linsendubletts ist. Eine zweite Gruppe optischer Komponente mit insgesamt negativer Brechkraft wird durch die zweite Linse des Dubletts sowie eine darauf folgende plan-konkave Linse gebildet. Darauf folgt eine dritte Gruppe optischer Komponenten mit insgesamt positiver Brechkraft, die vier Einzellinsen umfaßt. Eine vierte Gruppe optischer Komponenten mit insgesamt negativer Brechkraft besteht aus einem darauf folgenden Linsendublett. Die übrigen Linsen des Projektionsobjektivs bilden eine fünfte Gruppe optischer Komponenten mit insgesamt positiver Brechkraft. Zur Korrektur eines Vergrößerungsfehlers und einer Verzeichnung kann das erste Dublett, d. h. die erste Gruppe sowie die erste Linse der zweiten Gruppe, längs der optischen Achse verschoben werden. Außerdem kann die erste Linse der dritten Gruppe längs der optischen Achse zur Fehlerkorrektur verschoben werden.

Ähnliche Projektionsoptiken sind aus der DE-A-198 55 108 und der DE-A-199 42 281 der Anmelderin bekannt. Sie eignen sich insbesondere zum Einsatz mit Projektionslichtwellenlängen im DUV-Wellenlängenbereich. In diesen Druckschriften ist anstelle der fünften Gruppe optischer Komponenten mit insgesamt positiver Brechkraft stellenweise auch von einer fünften und einer sechsten Gruppe optischer Komponenten die Rede, die zu Zwecken der Beschreibung der nachfolgenden Erfindung jedoch zu einer fünften Gruppe optischer Komponenten mit insgesamt positiver Brechkraft zusammengefaßt werden können.

Bedingt durch die sehr hohe numerische Apertur, die Projektionsoptiken dieses Typs in der Regel aufweisen, treten Restabbildungsfehler auf, z.B. aufgrund von Änderungen der Umgebungsparameter wie Temperatur und Luftdruck.

Aus der EP-A2-1 245 984, deren Inhalt als Stand der Technik gemäß Artikel 54(3) EPÜ gilt, ist eine Projektionsbelichtungsanlage gemäß dem Oberbegriff des Anspruchs 1 bekannt. Eine Aperturblende ist dort jedoch nicht in, sondern vor der fünften Gruppe angeordnet.

Es ist daher die Aufgabe der vorliegenden Erfindung, eine Projektionsoptik für eine Projektionsbelichtungsanlage der eingangs genannten Art zu schaffen, deren Restabbildungsfehler verringert sind.

Diese Aufgabe wird erfindungsgemäß durch eine Projektionsbelichtungsanlage mit den Merkmalen des Anspruchs 1 gelöst.

Erfindungsgemäß wurde erkannt, daß dann, wenn mindestens drei optische Untergruppen gemäß obiger Auswahl als längs der optischen Achse verschiebbare Korrektureinrichtungen für Abbildungsfehler der Projektionsoptik gewählt werden, eine gute Korrektur der typischerweise auftretenden Abbildungsfehler, z. B. des Maßstabs, der Verzeichnung und der Bildfeldkrümmung gewährleistet ist. Hierbei müssen die einzelnen Untergruppen nicht selektiv auf jeweils einen Abbildungsfehler wirken, sondern es reicht aus, wenn die Kombination der Wirkungen der drei Untergruppen den gewünschten Korrektureffekt bringt. Die optimale Einstellung der jeweiligen Untergruppen kann mit Hilfe bekannter optischer Designprogramme ermittelt werden.

Bevorzugt ist die zweite optische Untergruppe der ersten Gruppe optischer Komponenten benachbart angeordnet.
In diesem Fall liegen mindestens zwei räumlich benachbarte verschiebbare Untergruppen vor, was die Möglichkeit einer baulichen Vereinfachung der Projektionsoptik bietet.

Die dritte optische Untergruppe kann im Übergangsbereich zwischen der dritten und der vierten Gruppe optischer Komponenten angeordnet sein, wobei der Übergangsbereich die im Strahlengang vorletzte oder letzte optische Komponente der dritten Gruppe und die erste optische Komponente der vierten Gruppe umfaßt. Für die meisten Designs von Projektionsoptiken der eingangs genannten Art ergibt sich in diesem Fall eine gute Korrektur von typischerweise auftretenden Abbildungsfehlern.

Als zweite optische Untergruppe kann ein Paar optischer Komponenten vorgesehen sein, deren Verschiebung längs der optischen Achse zwangsweise miteinander gekoppelt ist. Ein derartiges Komponentenpaar hat sich als effizient in der optischen Korrekturwirkung herausgestellt, wie optische Rechnungen gezeigt haben.

Bevorzugt ist dabei ein längs der optischen Achse der Projektionsoptik verschiebbarer Tragkörper vorgesehen, der beide optischen Komponenten gemeinsam haltert. Dies ermöglicht einen einfachen mechanischen Aufbau für die gemeinsam verschiebbaren optischen Komponenten.

Zusätzlich kann eine Verstelleinrichtung zum Verändern der Wellenlänge vorgesehen sein. Erfindungsgemäß wurde festgestellt, daß eine Verstelleinrichtung für die Wellenlänge in vielen Fällen die Korrekturfunktion einer zusätzlichen verschiebbaren Untergruppe optischer Komponenten ausüben kann. Die Wellenlängenverstellung ist in den meisten Fällen einfacher realisierbar als eine zusätzlich verschiebbare Untergruppe.

Bevorzugt ist dabei die Verstelleinrichtung so ausgeführt, daß durch sie die Emissionswellenlänge der Lichtquelle geändert wird. Eine derartige Verstelleinrichtung ist energieeffizient.

Alternativ oder zusätzlich kann die Verstelleinrichtung so ausgeführt sein, daß sie aus von der Lichtquelle erzeugten Licht eine Projektionslichtwellenlänge auswählt. Eine derartige Verstelleinrichtung ist einfach, z.B. durch Farbfilter, realisierbar.

Bei einer bevorzugten Weiterbildung ist eine weitere längs der optischen Achse verschiebbare optische Untergruppe aus mindestens einer optischen Komponente, die mindestens eine optische Komponente aus der fünften Gruppe optischer Komponenten umfaßt, vorgesehen. Mit Hilfe einer derartigen zusätzlichen optischen Untergruppe lassen sich weitere typischerweise auftretende Abbildungsfehler wie Koma und sphärische Aberration reduzieren.

Die weitere optische Untergruppe kann genau zwei optische Komponenten umfassen. Eine derartige Ausführung liefert bei vergleichsweise geringem mechanischen Aufwand eine gute Reduktion auftretender Abbildungsfehler, wie optische Rechnungen gezeigt haben.

Die optischen Komponenten können als refraktive Komponenten ausgeführt sein. Mit refraktiven optischen Komponenten läßt sich eine Projektionsoptik der eingangs genannten Art mit relativ geringem konstruktiven Aufwand realisieren. Alternativ ist es jedoch genauso möglich, die Projektionsoptik mit reflektiven Komponenten auszuführen.

Ausführungsbeispiele der Erfindung werden nachfolgend anhand der Zeichnung näher erläutert; es zeigen
- Figur 1: einen Linsenschnitt eines nicht erfindungsgemäßen Projektionsobjektivs einer Projektionsbelichtungsanlage;
- Figur 2: einen zu Figur 1 ähnlichen Linsenschnitt eines erfindungsgemäßen Projektionsobjektivs; und
- Figur 3: einen zu Figur 1 ähnlichen Linsenschnitt eines weiteren erfindungsgemäßen Projektionsobjektivs.

Die nachfolgend anhand ihrer Linsendesigns beschriebenen Projektionsobjektive dienen im Rahmen der mikrolithographischen Projektionsbelichtung der Abbildung einer auf einer Maske befindlichen Struktur auf einen Wafer, wobei das Bild der Struktur in einem korrigierten Bildfeld des Projektionsobjektivs liegt. Die gezeigten Projektionsobjektive sind refraktive Systeme und die dort eingesetzten Linsen sind alle aus Quarzglas. Die Projektionsobjektive sind ausgelegt auf einen Betrieb mit der Wellenlänge eines KrF-Excimerlasers bei 248 nm. Zur Veranschaulichung sind in den nachfolgenden Figuren die Strahlengänge zweier von jeweils einem Objektpunkt ausgehender Strahlenbündel durch das Objektiv dargestellt.

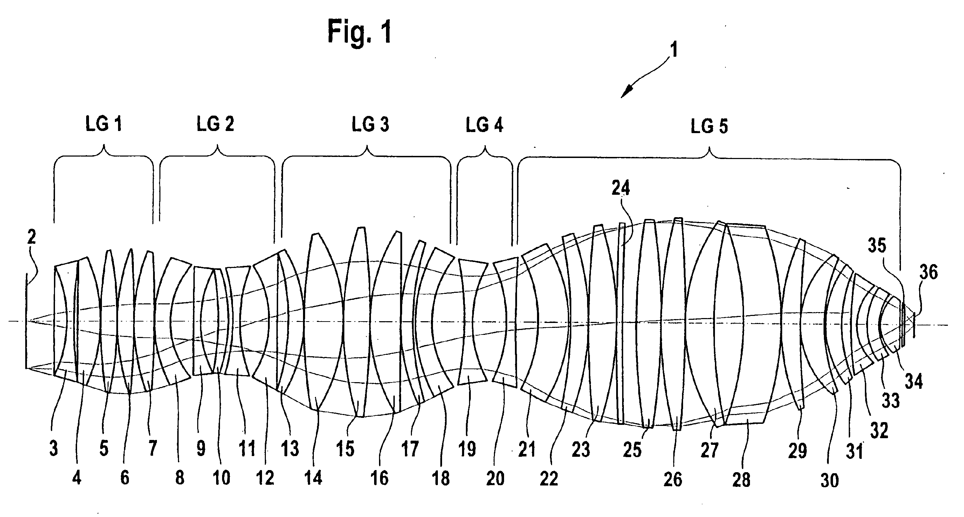

Beim in der Figur 1 insgesamt mit dem Bezugszeichen 1 bezeichneten Projektionsobjektiv, dessen Linsendaten in der Tabelle 3 der DE-A-19855 108, veröffentlicht sind, ist eine Maske 2 in der Objektebene des Projektionsobjektivs angeordnet.

In Strahlrichtung des Projektionslichtbündels ist hinter der Maske 2 eine erste Linsengruppe LG1 mit insgesamt positiver Brechkraft angeordnet, die insgesamt fünf Linsen 3, 4, 5, 6 und 7 aufweist.

In Projektionsstrahlrichtung schließt sich an die erste Linsengruppe LG1 mit insgesamt positiver Brechkraft eine zweite Linsengruppe LG2 mit insgesamt negativer Brechkraft an, die ebenfalls fünf Linsen 8, 9, 10, 11, 12 umfaßt.
Auf die zweite Linsengruppe LG2 folgt eine dritte Linsengruppe LG3 mit insgesamt positiver Brechkraft, umfassend insgesamt sechs Linsen 13, 14, 15, 16, 17, 18. Hieran schließt sich eine vierte Linsengruppe LG4 mit insgesamt negativer Brechkraft und zwei Linsen 19, 20 an. Die restlichen optischen Komponenten des Projektionsobjektivs 1 lassen sich in eine fünfte Linsengruppe LG5 mit insgesamt positiver Brechkraft zusammenfassen. Diese weist in Projektionsstrahlrichtung zunächst drei Linsen 21, 22, 23 auf, auf die eine planparallele Platte 24 folgt. Im weiteren Verlauf folgen in Projektionsstrahlrichtung zehn Linsen 25, 26, 27, 28, 29, 30, 31, 32, 33, 34. Durch eine weitere planparallele Platte 35 ist das Projektionsobjektiv 1 zu einem in der Bildebene des Projektionsobjektivs 1 befindlichen Wafer 36 hin abgeschlossen.

Nachfolgend werden bezugnehmend auf das Linsendesign der Figur 1 verschiedene Projektionsobjektive mit diesem Linsendesign beschrieben, die jeweils verschiedene Kombinationen von Korrektureinrichtungen für Abbildungsfehler aufweisen. Die Korrekturkomponenten umfassen mehrere, jeweils mindestens eine optische Komponente umfassende Untergruppen optischer Komponenten, die in Richtung der optischen Achse verschiebbar sind.

Allen diesen Projektionsobjektiven und auch den in Zusammenhang mit den noch folgenden Figuren beschriebenen Projektionsobjektiven mit Korrektureinrichtungen ist folgender Aufbau gemeinsam:

Es ist das die Maske 2 haltende Retikel oder mindestens eine Linse aus der ersten Linsengruppe LG1 in Richtung der optischen Achse verschiebbar. Die Maske 2 und die Linsen aus der Linsengruppe LG1 können daher als zu einer ersten Untergruppe optischer Komponenten gehörend angesehen werden.

Unabhängig davon ist mindestens eine Linse aus der zweiten oder der dritten Linsengruppe LG2, LG3 in Richtung der optischen Achse verschiebbar. Diese Linsen aus der zweiten oder der dritten Linsengruppe LG2, LG3 können daher als zu einer zweiten Untergruppe optischer Komponenten gehörend angesehen werden.

Schließlich ist noch mindestens eine Linse aus der dritten oder der vierten Linsengruppe LG3, LG4 in Richtung der optischen Achse verschiebbar. Diese Linsen aus der dritten oder der vierten Linsengruppe LG3, LG4 können daher als zu einer dritten Untergruppe optischer Komponenten gehörend angesehen werden.

Mit diesen allen Projektionsobjektiven gemeinsamen Korrektureinrichtungen lassen sich die Bildfehler Maßstab, Verzeichnung und Bildfeldkrümmung kompensieren, wie nachfolgend noch quantitativ gezeigt wird.

Zusätzlich zu den genannten Korrektureinrichtungen können Korrektureinrichtungen vorgesehen sein, die einerseits zur Optimierung der Kompensation der o. g. Bildfehler dienen und andererseits zusätzlich noch die Bildfehler Koma und sphärische Aberration beeinflussen können. Neben der Manipulation optischer Komponenten in Richtung der optischen Achse kommt hierfür grundsätzlich noch die Änderung der Projektionslichtwellenlänge in Frage.

Die Wirksamkeit der einzelnen Beispiele wird anhand des Werts einer Meritfunktion diskutiert, der sich aus der Summe der Quadrate der Zernikekoeffizienten, aufsummiert über die Bildfeldpunkte, ergibt. Diese Meritfunktion kann mit Hilfe eines optischen Designprogramms ausgewertet werden.

Zur Bewertung der Wirksamkeit wird eine bestimmte Kombination von Bildfehlern vorgegeben und dann quantitativ ermittelt, inwieweit diese mit Hilfe der je nach Beispiel vorgegebenen Korrektureinrichtungen kompensiert werden kann.

Bei einem ersten Beispiel sind beim Projektionsobjektiv 1 das die Maske 2 haltende Retikel, die Linsen 8 und 9 sowie die Linse 17 in Richtung der optischen Achse verschiebbar. Die Linsen 8 und 9 sind hierbei nicht unabhängig voneinander verschiebbar, sondern gemeinsam als Gruppe. Hierzu sind die Linsen 8, 9 gemeinsam auf einem längs der optischen Achse verschiebbaren, in der Zeichnung nicht dargestellten Tragkörper angeordnet.

Für die Korrektureinrichtungen gemäß dem ersten Beispiel wurden zur Bestimmung der Korrekturwirkung folgende Bildfehlerwerte als Ausgangswerte herangezogen: 50 ppm für den Maßstab, 50 nm für die Verzeichnung und 100 nm für die Bildfeldkrümmung gekoppelt im Verhältnis 1:1 an 100 nm Astigmatismus, da diese Bildfehler nur simultan mit Z-Manipulatoren korrigiert werden können. Mit Hilfe der Korrektureinrichtungen gemäß dem ersten Beispiel läßt sich der Wert der Meritfunktion für diese Ausgangswerte auf einen Endwert verringern, dessen Absolutwert nur noch 1,9 % des Ausgangswerts beträgt.

In der ersten Zeile der am Ende der Beschreibung angegebenen Tabelle 1 sind die statistischen Summen über die Restbildfehler nach der Kompensation der drei oben genannten Ausgangsbildfehler mit den Korrektureinrichtungen des ersten Beispiels dargestellt. Hier sind die Werte für die Verzeichnung (Disto), Focal Plane Deviation (FPD), Astigmatismus (AST) als geometrische Bildfehler sowie die wichtigsten Wellenfrontfehler als Zernikekoeffizienten (Z7, Z9, Z10, Z12, Z14, Z16, Z17, Z25) angegeben. Der Restbildfehler ist der Maximalwert eines Bildfehlers, z.B. der Verzeichnung, im Bildfeld. Bei jeder Kompensation eines Modellbildfehlerverlaufes wird der Restbildfehler bestimmt. Beim statistischen Aufsummieren wird die Wurzel aus der Summe der Quadrate der einzelnen aus den Kompensationen erhaltenen Restbildfehler gebildet.

Beim zweiten Beispiel weist das Projektionsobjektiv 1 als Korrektureinrichtungen in Richtung der optischen Achse verschiebbare Linsen 6, 8, 9 sowie 17 auf. Das Retikel 2 ist hier nicht verschiebbar. Auch hier sind die Linsen 8 und 9 nicht unabhängig voneinander, sondern gemeinsam als Gruppe in Richtung der optischen Achse verschiebbar. Analog zum oben im Zusammenhang mit dem ersten Beispiel Ausgeführten werden auch hier anhand der gleichen Ausgangswerte für die Bildfehler Maßstab, Verzeichnung und Bildfeldkrümmung die Reduktion des Werts der Meritfunktion sowie die Restbildfehler nach erfolgter Kompensation berechnet. Die Meritfunktion reduziert sich auf 1,7 % des Ausgangswerts.

Die Werte für die Restbildfehler sind in der zweiten Zeile der Tabelle 1 eingetragen. Insbesondere der Verzeichnungswert ist gegenüber dem ersten Beispiel nochmals deutlich verringert.

Bei einem dritten Beispiel werden folgende Korrektureinrichtungen beim Projektionsobjektiv 1 eingesetzt: Ein in Richtung der optischen Achse verschiebbares, die Maske 2 haltendes Retikel, in Richtung der optischen Achse verschiebbare Linsen 8, 9, 17 sowie 31 sowie eine Verstellung der Wellenlänge des Projektionslichts. Auch hier sind die Linsen 8 und 9 nicht unabhängig voneinander sondern gemeinsam als Gruppe verschiebbar.

Bei diesem Beispiel ist also zusätzlich noch eine Linse aus der fünften Linsengruppe LG5 verschiebbar. Diese Linsen aus der fünften Linsengruppe LG5 können daher als zu einer weiteren Untergruppe optischer Komponenten gehörend angesehen werden.

Zur Verstellung der Wellenlänge des Projektionslichts kann die Emissionswellenlänge der Lichtquelle geändert werden. Bei einem Laser kann dies z.B. durch ein resonatorinternes dispersives optisches Element, z.B. ein Gitter, erfolgen. Alternativ ist es möglich, die Wellenlänge des Projektionslichts nach Austritt aus der Lichtquelle zu ändern. Dies geschieht z.B. ebenfalls durch ein verstellbares dispersives optisches Element, z.B. ein Gitter oder ein Prisma, welches in diesem Fall in Bezug auf die Lichtquelle extern angeordnet ist. Auch der Einsatz eines Farbfilters zur Wellenlängenänderung ist möglich.

Werden hier zusätzlich zu den Ausgangs-Bildfehlerwerten für den Maßstab, die Verzeichnung und die Bildfeldkrümmung (vgl. das erste Ausführungsbeispiel) noch Fehlerwerte für Koma (10 nm Z7) und sphärische Aberration (10 nm Z9) angenommen, so ergibt sich eine Reduktion des in diesem Fall resultierenden Ausgangswerts der Meritfunktion nach der Kompensation durch die Korrektureinrichtungen des zweiten Beispiels auf nur noch 0,78 % des Ausgangswerts. Die resultierenden Restbildfehler sind aus der dritten Zeile der Tabelle 1 ersichtlich. Im Vergleich zum ersten und zweiten Beispiel sind die geometrischen Bildfehler deutlich verringert. Bei den höheren Zernikekoeffizienten ergibt sich eine leichte Zunahme der Absolutwerte, die hauptsächlich auf die zusätzlich eingeführten Fehlerwerte für Koma und sphärische Aberration zurückzuführen ist.

Beim vierten Beispiel sind beim Projektionsobjektiv 1 als Korrektureinrichtungen vorgesehen: Ein in Richtung der optischen Achse verschiebbares, die Maske 2 haltendes Retikel, verschiebbare Linsen 8, 9, 17, 23 und 31. Auch hier sind die Linsen 8 und 9 nicht unabhängig voneinander verstellbar, sondern gemeinsam als Gruppe. Werden die gleichen Ausgangs-Bildfehler wie beim dritten Beispiel angenommen, ergibt sich eine Reduktion der Meritfunktion auf 0,67 % des Ausgangswerts. Die Restbildfehler-Daten sind in der vierten Zeile der Tabelle 1 eingetragen. Insbesondere bei den höheren Zernike-Koeffizienten ergeben sich hier Verringerungen der Absolutwerte gegenüber dem dritten Ausführungsbeispiel.

Bei einem fünften Beispiel sind beim Projektionsobjektiv 1 folgende Korrektureinrichtungen vorgesehen: In Richtung der optischen Achse verschiebbare Linsen 6, 8, 9, 17, 23 sowie 31. Das Retikel 2 ist nicht verschiebbar. Auch hier sind die Linsen 8 und 9 nicht unabhängig voneinander verschiebbar sondern gemeinsam als Gruppe. Hier ergibt sich eine Reduktion der Meritfunktion auf 0,60 % des Ausgangswerts. Die Restbildfehlerdaten sind in der fünften Zeile der Tabelle 1 eingetragen. Diese Daten entsprechend in etwa denjenigen des vierten Beispiels.

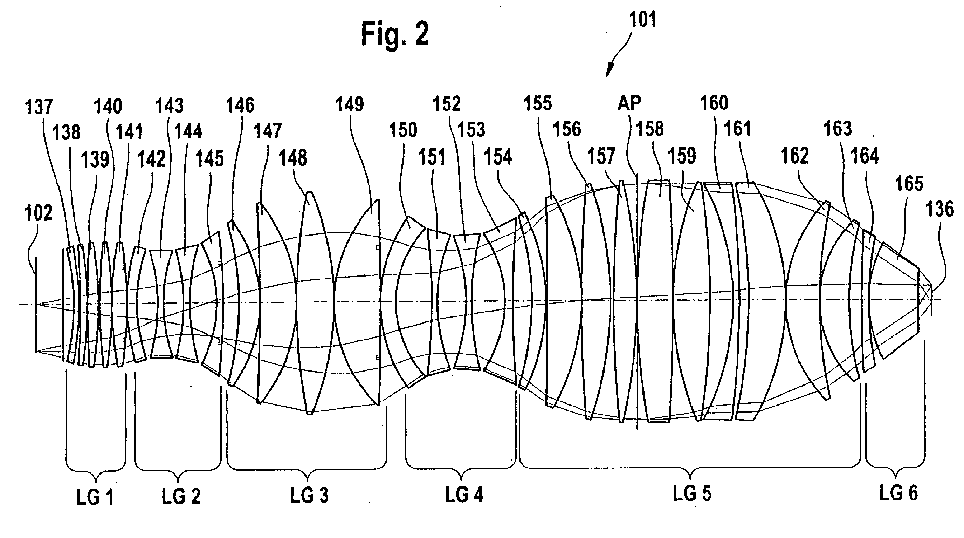

Ein zweites Projektionsobjektiv 101, für das nachfolgend eine Reihe von Ausführungsbeispielen von Korrektureinrichtungskombinationen besprochen wird, ist in Figur 2 dargestellt. Komponenten, die denjenigen entsprechen, die schon in Zusammenhang mit der Figur 1 erläutert wurden, tragen um 100 erhöhte Bezugszeichen und werden nicht nochmals im einzelnen erläutert.

Die Linsendaten zum Projektionsobjektiv 101 sind aus der DE-A-199 42 281, Tabelle 4, bekannt.

Die erste Linsengruppe LG1 umfaßt beim Projektionsobjektiv 101 fünf Linsen 137, 138, 139, 140, 141. Die zweite Linsengruppe LG2 ist aufgebaut aus vier Linsen 142, 143, 144, 145. Die dritte Linsengruppe LG3 weist insgesamt vier Linsen 146, 147, 148, 149 auf. Die vierte Linsengruppe LG4 umfaßt die vier Linsen 150, 151, 152, 153.

Im Unterschied zum Projektionsobjektiv 1 sind die auf die Linsengruppe LG4 folgenden Linsen ihrerseits in zwei Linsengruppen aufgeteilt: Auf die Linsengruppe LG4 folgt in Projektionsstrahlrichtung zunächst eine Linsengruppe LG5 mit insgesamt positiver Brechkraft. Diese weist insgesamt 10 Linsen 154, 155, 156, 157, 158, 159, 160, 161, 162, 163 auf. Zwischen den Linsen 157, 158 ist in einer Pupillenebene des Projektionsobjektivs 101 eine Aperturblende AP angeordnet.

Auf die Linsengruppe LG5 folgt in Projektionsstrahlrichtung eine Linsengruppe LG6, ebenfalls mit insgesamt positiver Brechkraft. Diese weist insgesamt zwei Linsen 164, 165 auf, wobei die Linse 164 eine negative Brechkraft hat. Die beiden letzten Linsengruppen LG5, LG6 können als eine Linsengruppe mit insgesamt positiver Brechkraft aufgefaßt werden.

Die Linse 165 ist dem Wafer 136 benachbart.

Bei einem ersten Ausführungsbeispiel einer Kombination von Korrektureinrichtungen weist das Projektionsobjektiv 101 der Figur 2 folgende Korrektureinrichtungen auf: Ein in Richtung der optischen Achse verschiebbares, die Maske 102 haltendes Retikel, in Richtung der optischen Achse verschiebbare Linsen 141, 142, 149. Die Linsen 141, 142 sind hierbei nicht unabhängig voneinander, sondern nur gemeinsam als Gruppe verschiebbar.

Zur Beurteilung der Wirksamkeit dieser Korrektureinrichtungen werden wiederum dieselben Ausgangs-Bildfehler für den Maßstab, die Verzeichnung und die Bildfeldkrümmung angenommen wie schon beim ersten Beispiel. Beim ersten Ausführungsbeispiel reduziert sich die Meritfunktion auf 3,3 % des Ausgangswerts. Die Restbildfehlerdaten sind aus der sechsten Zeile der Tabelle 1 ersichtlich.

Bei einem zweiten Ausführungsbeispiel liegen beim Projektionsobjektiv 101 folgende Korrektureinrichtungen vor: In Richtung der optischen Achse verschiebbare Linsen 140, 141, 142 sowie 149. Das Retikel 102 ist nicht verschiebbar. Auch hier sind die Linsen 141, 142 nicht unabhängig voneinander, sondern gemeinsam als Gruppe verschiebbar. Bei Annahme der Ausgangs-Bildfehler gemäß dem ersten Beispiel ergibt sich hier eine Reduktion der Meritfunktion auf 2,7 % des Ausgangswerts. Die Restbildfehlerdaten sind in die siebte Zeile der Tabelle 1 eingetragen.

Bei einem dritten Ausführungsbeispiel liegen folgende Korrektureinrichtungen beim Projektionsobjektiv 101 vor: Ein in Richtung der optischen Achse verschiebbares, die Maske 102 haltendes Retikel, verschiebbare Linsen 140, 141, 142 und 149 sowie eine Wellenlängen-Verstellung. Die Linsen 141, 142 sind hierbei nicht unabhängig voneinander, sondern nur gemeinsam als Gruppe verschiebbar.

Auch hier werden wie bei den Beispielen 3 bis 5 zusätzlich zu den Ausgangs-Bildfehlern für den Maßstab, die Verzeichnung und die Bildfeldkrümmung noch Ausgangs-Bildfehler für die Koma (10 nm Z7) und die sphärische Aberration (10 nm Z9) angenommen. Beim dritten Ausführungsbeispiel ergibt sich eine Reduktion der für diese Ausgangs-Bildfehler berechneten Meritfunktion auf 1,5 % des Ausgangswerts nach Einsatz der Korrektureinrichtungen. Die Restbildfehlerdaten ergeben sich aus der achten Zeile der Tabelle 1.

Bei einem vierten Ausführungsbeispiel weist das Projektionsobjektiv 101 folgende Korrektureinrichtungen auf: Ein in Richtung der optischen Achse verschiebbares, die Maske 102 haltendes Retikel, in Richtung der optischen Achse verschiebbare Linsen 140, 141, 142, 149 sowie 157. Auch hier sind die Linsen 141, 142 nicht unabhängig voneinander, sondern gemeinsam als Gruppe verschiebbar. Bei Annahme der gleichen Ausgangs-Bildfehler wie beim dritten Ausführungsbeispiel ergibt sich hier eine Reduktion der Meritfunktion auf 1,4 % des Ausgangswerts. Die Restbildfehlerdaten ergeben sich aus der neunten Zeile der Tabelle 1.

Bei einem fünften Ausführungsbeispiel sind beim Projektionsobjektiv 101 folgende Korrektureinrichtungen vorgesehen: In Richtung der optischen Achse verschiebbare Linsen 140, 141, 142, 149, 157, 159. Das Retikel 102 ist nicht verschiebbar. Auch hier sind die Linsen 141, 142 nicht unabhängig voneinander, sondern gemeinsam als Gruppe verschiebbar. Bei Annahme von Ausgangs-Bildfehlern wie beim dritten Ausführungsbeispiel ergibt sich hier eine Reduktion der Meritfunktion auf 1,4 % des Ausgangswerts. Die Restbildfehlerdaten ergeben sich aus der zehnten Zeile der Tabelle 1.

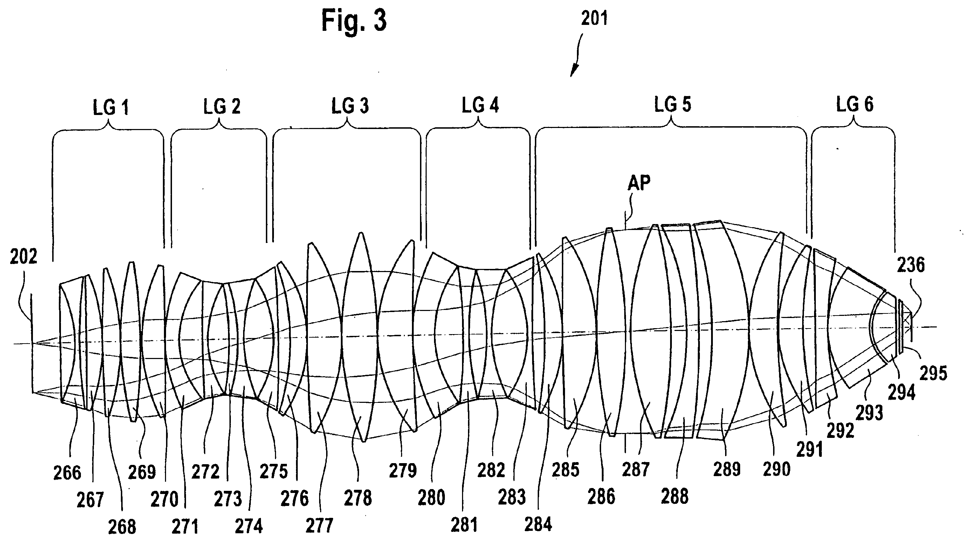

Ein drittes Projektionsobjektiv 201, für das nachfolgend weitere Ausführungsbeispiele von Kombinationen für Korrektureinrichtungen gegeben werden, ist in Figur 3 dargestellt. Komponenten, die denjenigen entsprechen, die schon unter Bezugnahme auf die Figuren 1 bzw. 2 erläutert wurden, tragen um 200 bzw. 100 erhöhte Bezugszeichen und werden nicht nochmals im einzelnen beschrieben.

Die Linsendaten zum Projektionsobjektiv 201 sind aus der DE-A-199 42 281, Tabelle 1, bekannt.

Die erste Linsengruppe LG1 des Projektionsobjektivs 201 weist insgesamt fünf Linsen 266, 267, 268, 269, 270 auf. Die zweite Linsengruppe LG2 des Projektionsobjektivs 201 ist aufgebaut aus insgesamt fünf Linsen 271, 272, 273, 274, 275. Die dritte Linsengruppe LG3 des Projektionsobjektivs 201 umfaßt insgesamt vier Linsen 276, 277, 278, 279. Die vierte Linsengruppe LG4 des Projektionsobjektivs 201 weist insgesamt vier Linsen 280, 281, 282, 283 auf.

Das Projektionsobjektiv 201 der Figur 3 ist im Blick auf die Linsengruppen LG5, LG6 analog zum Projektionsobjektiv 101 der Figur 2 aufgebaut. Die fünfte Linsengruppe des Projektionsobjektiv 201 umfaßt insgesamt acht Linsen 284, 285, 286, 287, 288, 289, 290, 291. Zwischen den Linsen 286, 287 ist im Bereich einer Pupillenebene des Projektionsobjektivs 201 eine Aperturblende AP vorgesehen. Die sechste Linsengruppe LG6 des Projektionsobjektivs 201 umfaßt in Projektionsstrahlrichtung zunächst drei Linsen 292, 293, 294 sowie eine das Projektionsobjektiv 201 in Richtung des Wafers 236 abschließende planparallele Platte 295.

Bei einem sechsten Ausführungsbeispiel sind beim Projektionsobjektiv 201 der Figur 3 folgende Korrektureinrichtungen vorgesehen: Ein in Richtung der optischen Achse verschiebbares, die Maske 202 haltendes Retikel, in Richtung der optischen Achse verschiebbare Linsen 271, 272 sowie 280. Die Linsen 271, 272 sind nicht unabhängig voneinander verschiebbar, sondern gemeinsam als Gruppe.

Mit den Ausgangs-Bildfehlern für den Maßstab, die Verzeichnung und die Bildfeldkrümmung gemäß dem ersten Beispiel ergibt sich hier nach der Korrektur durch die Korrektureinrichtungen eine Reduktion der Meritfunktion auf 2,1 % des Ausgangswerts. Die Restbildfehlerdaten nach der Kompensation sind in die elfte Zeile der Tabelle 1 eingetragen.

Beim siebten Ausführungsbeispiel weist das Projektionsobjektiv 201 folgende Korrektureinrichtungen auf: In Richtung der optischen Achse verschiebbare Linsen 269, 271, 272 sowie 280. Das Retikel 202 ist nicht verschiebbar. Auch hier sind die Linsen 271, 272 nicht unabhängig voneinander, sondern gemeinsam als Gruppe verschiebbar. Mit den Ausgangs-Bildfehlern gemäß dem ersten Beispiel ergibt sich hier eine Reduktion der Meritfunktion auf 1,9 % des Ausgangswerts. Die Restbildfehlerdaten sind in die zwölfte Zeile der Tabelle 1 eingetragen.

Beim achten Ausführungsbeispiel liegen beim Projektionsobjektiv 201 folgende Korrektureinrichtungen vor: Ein in Richtung der optischen Achse verschiebbares, die Maske 202 halterndes Retikel, in Richtung der optischen Achse verschiebbare Linsen 269, 271, 272 und 279 sowie eine Wellenlängen-Verstellung. Auch hier sind die Linsen 271, 272 nicht unabhängig voneinander sondern gemeinsam als Gruppe verschiebbar. Beim achten Ausführungsbeispiel werden als Ausgangs-Bildfehler neben den o. g. für den Maßstab, die Verzeichnung und die Bildfeldkrümmung noch zusätzlich Ausgangs-Bildfehler für die Koma (10 nm Z7) und die sphärische Aberration (10 nm Z9) angenommen Mit den Korrektureinrichtungen des achten Ausführungsbeispiels ergibt sich eine Reduktion der Meritfunktion auf 1,02 % des Ausgangswerts. Die zugehörigen Restbildfehlerdaten sind in die dreizehnte Zeile der Tabelle 1 eingetragen.

Beim neunten Ausführungsbeispiel weist das Projektionsobjektiv 201 folgende Korrektureinrichtungen auf: Ein in Richtung der optischen Achse verschiebbares, die Maske 202 haltendes Retikel, in Richtung der optischen Achse unabhängig verschiebbare Linsen 271, 280, 286 und 290. Bei Annahme der Ausgangs-Bildfehler gemäß dem achten Ausführungsbeispiel ergibt sich hier eine Reduktion der Meritfunktion auf 0,82 % des Ausgangswerts. Die zugehörigen Restbildfehlerdaten sind in die vierzehnte Zeile der Tabelle 1 eingetragen.

Bei einem zehnten Ausführungsbeispiel sind beim Projektionsobjektiv 201 folgende Korrektureinrichtungen vorgesehen: In Richtung der optischen Achse unabhängig verschiebbare Linsen 268, 271, 280, 286 sowie 290. Das Retikel 202 ist nicht verschiebbar. Bei Annahme der Ausgangs-Bildfehler wie beim achten Ausführungsbeispiel ergibt sich hier eine Reduktion der Meritfunktion auf 0,68 % des Ausgangswerts. Die zugehörigen Restbildfehlerdaten sind in die fünfzehnte Zeile der Tabelle 1 eingetragen.

Beim elften Ausführungsbeispiel sind beim Projektionsobjektiv 201 folgende Korrektureinrichtungen vorgesehen: Ein in Richtung der optischen Achse verschiebbares, die Maske 202 haltendes Retikel, in Richtung der optischen Achse verschiebbare Linsen 271, 272, 280 und 284. Die Linsen 271, 272 sind nicht unabhängig voneinander, sondern nur gemeinsam als Gruppe verschiebbar.

Beim elften Ausführungsbeispiel wurden folgende Ausgangs-Bildfehler angenommen: 30 ppm Maßstab, 50 nm Verzeichnung dritter Ordnung sowie 0,25 µm mittlere Bildfeldkrümmung. Nach Durchführung der Korrektur mit den Korrektureinrichtungen des elften Ausführungsbeispiels ergeben sich die folgenden Restbildfehler als geometrische Längsaberrationen: Eine Koma am Feldrand von maximal 100 nm, eine Koma in der Feldzone von maximal 61 nm, eine Koma in der Aperturzone am Feldrand von maximal 154 nm sowie eine Variation der sphärischen Aberration im Bildfeld von maximal 85 nm.

Beim zwölfen Ausführungsbeispiel sind beim Projektionsobjektiv 201 folgende Korrektureinrichtungen vorgesehen: Ein in Richtung der optischen Achse verschiebbares, die Maske 202 haltendes Retikel, in Richtung der optischen Achse unabhängig verschiebbare Linsen 271, 278, 280 und 284. Bei Annahme der gleichen Ausgangs-Bildfehler wie beim elften Ausführungsbeispiel ergeben sich folgende Restbildfehler als geometrische Längsaberrationen: Eine Koma in der Feldzone von maximal 15 nm, eine Koma in der Aperturzone am Feldrand von maximal 122 nm sowie eine Variation der sphärischen Aberration im Bildfeld von maximal 48 nm.

Beim dreizehnten Ausführungsbeispiel sind beim Projektionsobjektiv 201 die folgenden Korrektureinrichtungen vorgesehen: Ein in Richtung der optischen Achse verschiebbares, die Maske 202 haltendes Retikel, in Richtung der optischen Achse unabhängig verschiebbare Linsen 271, 280 und 284 sowie eine Wellenlängen-Verstellung. Bei Annahme von Ausgangs-Bildfehlern wie beim elften Ausführungsbeispiel ergeben sich nach der Korrektur durch die Korrektureinrichtungen beim dreizehnten Ausführungsbeispiel folgende Restbildfehler als geometrische Längsaberrationen: Eine Koma in der Feldzone von maximal 7 nm, eine Koma in der Aperturzone am Feldrand von maximal 112 nm sowie eine Variation der sphärischen Aberration im Bildfeld von maximal 123 nm.

In Abwandlung des ersten Beispiels bzw. sechsten Ausführungsbeispiels kann bei einem vierzehnten Ausführungsbeispiel als verschiebbare Einzellinse statt einer Linse im Bereich des Übergangs zwischen der dritten und vierten Linsengruppe LG3, LG4 auch die Linse der dritten Linsengruppe LG3 mit dem maximalen Durchmesser vorgesehen sein. D. h., statt der Linse 17 im ersten Beispiel wäre die Linse 15 verschiebbar und statt der Linse 280 im sechsten Ausführungsbeispiel wäre die Linse 278 verschiebbar.

In Abwandlung des dreizehnten Ausführungsbeispiels kann bei einem fünfzehnten Ausführungsbeispiel statt einer Linse im Bereich des Übergangs zwischen der ersten und der zweiten Linsengruppe LG1, LG2 (Linse 271 im dreizehnten Ausführungsbeispiel) auch eine Linse im Bereich des Übergangs zwischen der zweiten und der dritten Linsengruppe LG2, LG3 (z. B. die Linse 276 in Richtung der optischen Achse) verschiebbar ausgeführt sein.

Bei einer weiteren Abwandlung des dreizehnten Ausführungsbeispiels sind bei einem sechzehnten Ausführungsbeispiel statt der dort verschiebbaren Linsen 271, 280 und 284 folgende anderen Linsen in Richtung der optischen Achse verschiebbar: Zwei Linsen im Bereich des maximalen Durchmessers der dritten Linsengruppe LG3, z. B. die Linsen 278 und 279, sowie eine Linse im Bereich des Übergangs zwischen der dritten und der vierten Linsengruppe LG3, LG4, z. B. die Linse 280.

Die zur Bildfehlerkorrektur optimalen Positionen der einzelnen Korrektureinrichtungen werden folgendermaßen ermittelt:

Unter Berücksichtigung der vorgegebenen Ausgangs-Bildfehler werden alle möglichen Kombinationen der Einstellungen der Korrektureinrichtungen mit Hilfe eines bekannten optischen Designprogramms durch Bildfehlervorgaben und Auswertung einer Meritfunktion gemäß dem oben Ausgeführten analysiert. Kombinationen von Korrektureinrichtungen werden verworfen, bei denen ein Restbildfehler eine vorgegebene Obergrenze überschreitet, bei denen eine Korrektureinrichtung den maximal vorgegebenen Einstellbereich verläßt oder bei denen die Änderung der Einstellung einer Korrektureinrichtung zu einer Bildfehleränderung führt, die über einem vorgegebenen Grenzwert für die Änderung liegt. Dieser letzte Fall berücksichtigt die begrenzte Einstellgenauigkeit der Korrektureinrichtungen.

**Tabelle 1**

| Ausführungsbeispiel | Disto [nm] | FPD [nm] | AST [nm] | Z7 [nm] | Z9 [nm] | Z10 [nm] | Z12 [nm] | Z14 [nm] | Z16 [nm] | Z17 [nm] | Z25 [nm] |
|---|---|---|---|---|---|---|---|---|---|---|---|
| (Beisp. 1) | 4,66 | 12,74 | 9,29 | 2,36 | 3,17 | 0,37 | 0,23 | 0,57 | 0,41 | 0,03 | 0,06 |
| (Beisp. 2) | 2,21 | 13,13 | 7,50 | 2,07 | 3,19 | 0,37 | 0,21 | 0,49 | 0,42 | 0,03 | 0,06 |
| (Beisp. 3) | 0,35 | 9,90 | 4,75 | 0,54 | 0,35 | 1,00 | 0,70 | 0,95 | 0,86 | 0,04 | 0,11 |
| (Beisp. 4) | 0,29 | 10,40 | 5,04 | 0,39 | 0,28 | 0,51 | 0,56 | 0,76 | 0,74 | 0,03 | 0,10 |
| (Beisp. 5) | 0,32 | 8,30 | 4,03 | 0,41 | 0,28 | 0,54 | 0,48 | 0,64 | 0,74 | 0,03 | 0,09 |
| 1 | 5.6 | 28.08 | 72 | 9.97 | 4.36 | 0.39 | 1.11 | 235 | 0.95 | 1.02 | 0.78 |
| 2 | 4.43 | 26.4 | 5.77 | 8.74 | 3.51 | 0.36 | 0.98 | 2.04 | 0.87 | 0.89 | 0.68 |
| 3 | 2.23 | 20.9 | 7.9 | 1.27 | 0.88 | 1.09 | 1.18 | 2.44 | 1.57 | 1.42 | 1.21 |
| 4 | 2.32 | 21.1 | 8.3 | 1.06 | 0.83 | 0.47 | 1.13 | 1.98 | 1.41 | 0.96 | 0.76 |
| 5 | 2.34 | 21.71 | 8 | 0.77 | 0.58 | 0.6 | 1.11 | 1.92 | 1.5 | 0.78 | 0.7 |
| 6 | 5,42 | 21,03 | 13,70 | 2,95 | 3,82 | 0,96 | 0,35 | 0,40 | 0,64 | 0,06 | 0,12 |
| 7 | 3,16 | 18,16 | 8,50 | 3,02 | 3,97 | 0,81 | 0,34 | 0,35 | 0,61 | 0,05 | 0,10 |
| 8 | 0,96 | 10,78 | 3,87 | 0,80 | 0,56 | 0,79 | 1,01 | 1,90 | 1,24 | 0,56 | 0,43 |
| 9 | 0,34 | 16,26 | 7,17 | 0,32 | 0,50 | 0,53 | 0,35 | 0,82 | 1,00 | 0,03 | 0,18 |
| 10 | 0,29 | 11,37 | 5,06 | 0,35 | 0,35 | 0,49 | 0,35 | 0,82 | 0,90 | 0,02 | 0,13 |

## Patentansprüche

1. Projektionsbelichtungsanlage für die Mikrolithographie, zur Erzeugung eines Bilds einer
in einer Objektebene angeordneten Maske in einer Bildebene mit einer Projektionslicht emittierenden Lichtquelle und einer zwischen der Maske und dem Bild angeordneten Projektionsoptik, wobei im Strahlengang der Projektionsoptik ausgehend von der Maske angeordnet sind:
a) eine erste Gruppe (LG1) optischer Komponenten mit insgesamt positiver Brechkraft;
b) eine zweite Gruppe (LG2) optischer Komponenten mit insgesamt negativer Brechkraft;
c) eine dritte Gruppe (LG3) optischer Komponenten mit insgesamt positiver Brechkraft;
d) eine vierte Gruppe (LG4) optischer Komponenten mit insgesamt negativer Brechkraft und
e) eine fünfte Gruppe (LG5; LG5, LG6) optischer Komponenten mit insgesamt positiver Brechkraft,
wobei
f) mindestens drei optische Untergruppen (2, 8, 9, 17; 6, 8, 9, 17; 2, 8, 9, 17, 31; 2, 8, 9, 17, 23, 31; 6, 8, 9, 17, 23, 31; 102, 141, 142, 149; 140, 141, 142, 149; 102, 140, 141, 142, 149; 102, 140, 141, 142, 149, 157; 140, 141, 142, 149, 157, 159; 202, 271, 272, 280; 269, 271, 272, 280; 202, 269, 271, 272, 279; 202, 271, 280, 286, 290; 268, 271, 280, 286, 290; 202, 271, 272, 280, 284; 202, 271, 278, 280, 284; 202, 271, 280, 284; 202, 271, 272, 278; 202, 276, 280, 284; 202, 278, 279, 280), die jeweils mindestens eine optische Komponente enthalten, längs der optischen Achse der Projektionsoptik (1; 101; 201) verschiebbar sind,
g) die erste optische Untergruppe die Maske (2; 102; 202) oder mindestens eine optische Komponente (6; 140, 141; 268, 269) aus der ersten Gruppe (LG1) optischer Komponenten umfaßt,
h) die zweite optische Untergruppe mindestens eine optische Komponente (8, 9; 142; 271, 272, 276, 278, 279) aus der zweiten (LG2) oder der dritten (LG3) Gruppe optischer Komponenten umfaßt,
i) die dritte optische Untergruppe mindestens eine optische Komponente (17; 149; 278, 279, 280) aus der dritten (LG3) oder der vierten (LG4) Gruppe optischer Komponenten umfaßt,
**dadurch gekennzeichnet, daß**
die erste optische Untergruppe unabhängig von den optischen Komponenten (8, 9; 142; 271, 272, 276, 278, 279) aus der zweiten Gruppe (LG2) optischer Komponenten verschiebbar ist, und daß
in der fünften Gruppe (LG5) eine Aperturblende angeordnet ist.

2. Projektionsbelichtungsanlage nach Anspruch 1, **dadurch gekennzeichnet, daß** die zweite optische Untergruppe (8, 9; 141, 142; 271, 272) der ersten Gruppe (LG1) optischer Komponenten benachbart angeordnet ist.

3. Projektionsbelichtungsanlage nach Anspruch 1 oder 2,
**dadurch gekennzeichnet, daß** die dritte optische Untergruppe (17; 149; 279, 280) im Übergangsbereich zwischen der dritten (LG3) und der vierten (LG4) Gruppe optischer Komponenten angeordnet ist, wobei der Übergangsbereich die im Strahlengang vorletzte oder letzte Komponente der dritten Gruppe und die erste optische Komponente der vierten Gruppe umfaßt.

4. Projektionsbelichtungsanlage nach einem der vorhergehenden Ansprüche, **dadurch gekennzeichnet, daß** als zweite optische Untergruppe ein Paar optischer Komponenten (8, 9; 141, 142; 271, 272) vorgesehen ist, deren Verschiebung längs der optischen Achse zwangsweise miteinander gekoppelt ist.

5. Projektionsbelichtungsanlage nach Anspruch 4, **dadurch gekennzeichnet, daß** ein längs der optischen Achse der Projektionsoptik (1; 101; 201) verschiebbarer Tragkörper vorgesehen ist, der beide optischen Komponenten (8, 9; 141, 142; 271, 272) gemeinsam haltert.

6. Projektionsbelichtungsanlage nach einem der vorhergehenden Ansprüche, **dadurch gekennzeichnet, daß** eine Verstelleinrichtung zum Verändern der Wellenlänge vorgesehen ist.

7. Projektionsbelichtungsanlage nach Anspruch 6, **dadurch gekennzeichnet, daß** die Verstelleinrichtung so ausgeführt ist, daß durch sie die Emissionswellenlänge der Lichtquelle geändert wird.

8. Projektionsbelichtungsanlage nach Anspruch 6 oder 7, **dadurch gekennzeichnet, daß** die Verstelleinrichtung so ausgeführt ist, daß sie aus der von der Lichtquelle erzeugtem Licht eine Projektionslichtwellenlänge auswählt.

9. Projektionsbelichtungsanlage nach einem der vorhergehenden Ansprüche, **gekennzeichnet durch** mindestens eine weitere längs der optischen Achse der Projektionsoptik (1; 101; 201) verschiebbare optische Untergruppe (31; 23, 31; 157; 157, 159; 286, 290; 284) aus mindestens einer optischen Komponente, die mindestens eine optische Komponente (31; 23, 31; 157; 157, 159; 286, 290; 284) aus der fünften Gruppe (LG5; LG5, LG6) optischer Komponenten umfaßt.

10. Projektionsbelichtungsanlage nach Anspruch 9, **gekennzeichnet durch** genau zwei weitere längs der optischen Achse der Projektionsoptik verschiebbare optische Untergruppen (23, 32; 157, 159; 286, 290).

11. Projektonsbelichtungsanlage nach einem der vorhergehenden Ansprüche, **dadurch gekennzeichnet, daß** die optischen Komponenten (3 bis 35; 137 bis 165; 266 bis 295) als refraktive Komponenten ausgeführt sind.

## Claims

1. Projection exposure apparatus for microlithography, for generating, in an image plane, an image of a mask arranged in an object plane, comprising a light source emitting projection light and projection optics arranged between the mask and the image, wherein the following are arranged in the beam path of the projection optics, starting from the mask:
a) a first group (LG1) of optical components with an overall positive refractive power;
b) a second group (LG2) of optical components with an overall negative refractive power;
c) a third group (LG3) of optical components with an overall positive refractive power;
d) a fourth group (LG4) of optical components with an overall negative refractive power and
e) a fifth group (LG5; LG5, LG6) of optical components with an overall positive refractive power;
wherein
f) at least three optical subgroups (2, 8, 9, 17; 6, 8, 9, 17; 2, 8, 9, 17, 31; 2, 8, 9, 17, 23, 31; 6, 8, 9, 17, 23, 31; 102, 141, 142, 149; 140, 141, 142, 149; 102, 140, 141, 142, 149; 102, 140, 141, 142, 149, 157; 140, 141, 142, 149, 157, 159; 202, 271, 272, 280; 269, 271, 272, 280; 202, 269, 271, 272, 279; 202, 271, 280, 286, 290; 268, 271, 280, 286, 290; 202, 271, 272, 280, 284; 202, 271, 278, 280, 284; 202, 271, 280, 284; 202, 271, 272, 278; 202, 276, 280, 284; 202, 278, 279, 280) comprising at least one optical component can be displaced along the optical axis of the projection optics (1; 101; 201),
g) the first optical subgroup comprises the mask (2; 102; 202) or at least one optical component (6; 140, 141; 268, 269) from the first group (LG1) of optical components,
h) the second optical subgroup comprises at least one optical component (8, 9; 142; 271, 272, 276, 278, 279) from the second (LG2) or the third (LG3) group of optical components,
i) the third optical subgroup comprises at least one optical component (17; 149; 278, 279, 280) from the third (LG3) or the fourth (LG4) group of optical components,
**characterised in that**
the first optical subgroup can be displaced independently from the optical components (8, 9; 142; 271, 272, 276,278,279) of the second group (LG2) of optical components, and that
an aperture diaphragm is arranged in the fifth group (LG5).

2. Projection exposure apparatus according to claim 1, **characterised in that** the second optical subgroup (8, 9; 141, 142; 271, 272) is arranged next to the first group (LG1) of optical components.

3. Projection exposure apparatus according to claim 1 or 2, **characterised in that** the third optical subgroup (17; 149; 279, 280) is arranged in the transition region between the third (LG3) and the fourth (LG4) groups of optical components, wherein the transition region comprises the in the beam path penultimate or last optical component of the third group and the first optical component of the fourth group.

4. Projection exposure apparatus according to one of the preceding claims, **characterised in that** a pair of optical components (8, 9; 141, 142; 271, 272), whose displacements along the optical axis are constrainedly coupled together, is provided as the second optical subgroup.

5. Projection exposure apparatus according to claim 4, **characterised in that** a support body is provided, which can be displaced along the optical axis of the projection optics (1; 101; 201) and which commonly supports the two optical components (8, 9; 141, 142; 271, 272) together.

6. Projection exposure apparatus according to one of the preceding claims, **characterised in that** an adjustment instrument for changing the wavelength is provided.

7. Projection exposure apparatus according to claim 6, **characterised in that** the adjustment instrument is configured in such a way that the emission wavelength of the light source is altered by means of it.

8. Projection exposure apparatus according to claim 6 or 7, **characterised in that** the adjustment instrument is configured in such a way that it selects a projection light wavelength out of light generated by the light source.

9. Projection exposure apparatus according to one of the preceding claims, **characterised by** at least one further optical subgroup (31; 23, 31; 157; 157, 159; 286, 290; 284), which can be displaced along the optical axis of the projection optics (1; 101; 201) and which comprises at least one optical component (31; 23, 31; 157; 157, 159; 286, 290; 284) from the fifth group (LG5; LG5, LG6) of optical components.

10. Projection exposure apparatus according to claim 9, **characterised by** exactly two further optical subgroups (23, 32; 157, 159; 286, 290) which can be displaced along the optical axis of projection optics.

11. Projection exposure apparatus according to one of the preceding claims, **characterised in that** the optical components (3 to 35; 137 to 165; 266 to 295) are designed as refractive components.

## Revendications

1. Installation d'exposition par projection pour la microlithographie, permettant de générer une image d'un masque disposé dans un plan objet dans un plan image avec une source de lumière émettant une lumière de projection et une optique de projection disposée entre le masque et l'image, sachant que sont disposés dans le trajet des rayons de l'optique de projection, en partant du masque :
a) un premier groupe (LG1) de composants optiques de réfringence globalement positive ;
b) un deuxième groupe (LG2) de composants optiques de réfringence globalement négative ;
c) un troisième groupe (LG3) de composants optiques de réfringence globalement positive ;
d) un quatrième groupe (LG4) de composants optiques de réfringence globalement négative et
e) un cinquième groupe (LG5 ; LG5, LG6) de composants optiques de réfringence globalement positive,
sachant que
f) au moins trois sous-groupes optiques (2, 8, 9, 17 ; 6, 8, 9, 17 ; 2, 8, 9, 17, 31 ; 2, 8, 9, 17, 23, 31 ; 6, 8, 9, 17, 23, 31 ; 102, 141, 142, 149 ; 140, 141, 142, 149 ; 102, 140, 141, 142, 149 ; 102, 140, 141, 142, 149, 157 ; 140, 141, 142, 149, 157, 159 ; 202, 271, 272, 280 ; 269, 271, 272, 280 ; 202, 269, 271, 272, 279 ; 202, 271, 280, 286, 290 ; 268, 271, 280, 286, 290 ; 202, 271, 272, 280, 284 ; 202, 271, 278, 280, 284 ; 202, 271, 280, 284 ; 202, 271, 272, 278 ; 202, 276, 280, 284 ; 202, 278, 279, 280) qui contiennent chacun au moins un composant optique sont déplaçables le long de l'axe optique de l'optique de projection (1 ; 101 ; 201),
g) le premier sous-groupe optique comprend le masque (2 ; 102 ; 202) ou au moins un composant optique (6 ; 140, 141 ; 268, 269) du premier groupe (LG1) de composants optiques,
h) le deuxième sous-groupe optique comprend au moins un composant optique (8, 9 ; 142 ; 271, 272, 276, 278, 279) du deuxième groupe (LG2) ou du troisième groupe (LG3) de composants optiques,
i) le troisième sous-groupe optique comprend au moins un composant optique (17 ; 149 ; 278, 279, 280) du troisième groupe (LG3) ou du quatrième groupe (LG4) de composants optiques,
**caractérisée en ce que**
le premier sous-groupe optique est déplaçable indépendamment des composants optiques (8, 9 ; 142 ; 271, 272, 276, 278, 279) du deuxième groupe (LG2) et que
un diaphragme d'ouverture est disposé dans le cinquième groupe (LG5).

2. Installation d'exposition par projection selon la revendication 1, **caractérisée en ce que** le deuxième sous-groupe optique (8, 9 ; 141, 142 ; 271, 272) est disposé au voisinage du premier groupe (LG1) de composants optiques.

3. Installation d'exposition par projection selon la revendication 1 ou 2, **caractérisée en ce que** le troisième sous-groupe optique (17 ; 149 ; 279, 280) est disposé dans la zone de transition entre le troisième (LG3) et le quatrième (LG4) groupe de composants optiques, la zone de transition comprenant l'avant-dernier ou le dernier composant du troisième groupe et le premier composant optique du quatrième groupe dans le trajet des rayons.

4. Installation d'exposition par projection selon l'une des revendications précédentes, **caractérisée en ce qu'**il est prévu comme deuxième sous-groupe optique une paire de composants optiques (8, 9 ; 141, 142 ; 271, 272) qui sont couplés ensemble par contrainte dans leur déplacement le long de l'axe optique.

5. Installation d'exposition par projection selon la revendication 4, **caractérisée en ce qu'**il est prévu un corps porteur déplaçable le long de l'axe optique de l'optique de projection (1 ; 101 ; 201) qui maintient ensemble les deux composants optiques (8, 9 ; 141, 142 ; 271, 272).

6. Installation d'exposition par projection selon l'une des revendications précédentes, **caractérisée en ce qu'**il est prévu un dispositif de réglage pour modifier la longueur d'onde.

7. Installation d'exposition par projection selon la revendication 6, **caractérisée en ce que** le dispositif de réglage est réalisé de manière qu'il permette de modifier la longueur d'onde d'émission de la source de lumière.

8. Installation d'exposition par projection selon la revendication 6 ou 7, **caractérisée en ce que** le dispositif de réglage est réalisé de manière qu'il sélectionne une longueur d'onde de lumière de projection à partir de la lumière générée par la source de lumière.

9. Installation d'exposition par projection selon l'une des revendications précédentes, **caractérisée par** au moins un autre sous-groupe optique (31 ; 23, 31 ; 157 ; 157, 159 ; 286, 290 ; 284) déplaçable le long de l'axe optique de l'optique de projection (1 ; 101 ; 201) et composé d'au moins un composant optique qui comprend au moins un composant optique (31 ; 23, 31 ; 157 ; 157, 159 ; 286, 290 ; 284) du cinquième groupe (LG5 ; LG5, LG6) de composants optiques.

10. Installation d'exposition par projection selon la revendication 9, **caractérisée par** exactement deux autres sous-groupes optiques (23, 32 ; 157, 159 ; 286, 290) déplaçables le long de l'axe optique de l'optique de projection.

11. Installation d'exposition par projection selon l'une des revendications précédentes, **caractérisée en ce que** les composants optiques (3 à 35 ; 137 à 165 ; 266 à 295) sont réalisés sous la forme de composants réfractifs.
